# EUROPÄISCHE PATENTSCHRIFT

(11) **EP 3 491 403 B1**
(45) Veröffentlichungstag und Bekanntmachung des Hinweises auf die Patenterteilung: **04.09.2024**
(21) Anmeldenummer: 17739974.8
(22) Anmeldetag: 14.07.2017
(51) Int. Cl.: G01R 31/28, G01R 31/70

(54) **TESTSYSTEM ZUR PRÜFUNG VON ELEKTRISCHEN VERBINDUNGEN VON BAUTEILEN MIT EINER LEITERPLATTE**
TEST SYSTEM FOR TESTING ELECTRIC CONNECTIONS BETWEEN COMPONENTS AND A PRINTED CIRCUIT BOARD
SYSTÈME DE TEST DESTINÉ À CONTRÔLER DES CONNEXIONS ÉLECTRIQUES DE COMPOSANTS COMPORTANT UNE CARTE DE CIRCUIT IMPRIMÉ

(30) Priorität: 01.08.2016 DE 102016114144
(43) Veröffentlichungstag der Anmeldung: 05.06.2019
(73) Patentinhaber: Endress+Hauser Flowtec AG, 4153 Reinach (CH)
(72) Erfinder: BÖHLER, Thomas, 79400 Kandern (DE); BRUDERMANN, Matthias, 4313 Moehlin (CH); WERLE, Christoph, 4410 Liestal (CH); WUCHER, Markus, 79541 Lörrach (DE); KOLLMER, Daniel, 79689 Maulburg (DE); ADAM, Ludovic, 68490 Chalampé (FR)
(74) Vertreter: Penner, Paul
(86) Internationale Anmeldenummer: PCT/EP2017/067810
(87) Internationale Veröffentlichungsnummer: WO 2018/024463

(56) Entgegenhaltungen:
- DE-A1- 102004 063 488
- US-A1- 2004 064 285
- US-A1- 2004 257 090
- US-A1- 2005 237 073
- US-A1- 2014 062 521
- US-A1- 2015 168 452
- US-B1- 6 427 216

## Beschreibung

Die vorliegende Erfindung betrifft ein Testsystem nach dem Oberbegriff des Anspruchs 1.

Die EP 0 633 478 A2 offenbart ein Testsystem zur Prüfung von elektrischen Verbindungen von elektronischen Bauteilen mit einer zu prüfenden Leiterplatte. Weiterer Stand der Technik findet sich in den Dokumenten US2004/064285A1, US2015/168452A1, US2014/062521A1, DE102004063488A1 und US6427216B1.

Derartige Testsysteme wurden sukzessive weiterentwickelt. So sind die Prüfspitzen durch bewegliche Achsen und/oder Roboterarme an die zu prüfende Leiterplatte heranführbar und ermitteln z.B. durch Widerstandsmessung, ob eine Lötverbindung richtig positioniert ist und eine elektrische Kontaktierung der elektronischen Bauteile der Leiterplatte über diese Lötverbindung erfolgt ist.

Zunehmend werden Leiterplatten nunmehr mit Kommunikationsmodulen, z.B. USB oder Ethernet-Steckverbindungen ausgestattet um auch einen Datentransfer zwischen anderen Leiterplatten oder externen elektronischen Geräten mit den elektronischen Bauteilen der Leiterplatten, insbesondere mit einem oder mehreren auf der Leiterplatte befindlichen Datenspeichern zu ermöglichen.

Hierfür weisen die derzeitigen gattungsgemäßen Testsysteme keine Möglichkeit der Funktionsprüfung auf.

Ausgehend vom bisherigen Stand der Technik ist es nunmehr Aufgabe der vorliegenden Erfindung eine funktionale Prüfung der Datenbahnen des zu prüfenden Leiterplatte durch ein vorgenanntes Testsystem zu ermöglichen.

Die vorliegende Erfindung löst diese Aufgabe durch ein Testsystem mit den Merkmalen des Anspruchs 1.

Das Testsystem zur Prüfung von elektrischen Verbindungen zwischen von elektronischen Bauteilen und einer zu prüfenden Leiterplatte, wobei die Leiterplatte ein Kommunikationsmodul und Kontaktierungsbereiche umfasst, umfassend:
- ein Gehäuse;
- eine Kommunikationsschnittstelle, welche durch Kontaktierung mit der Leiterplatte einen Datenaustausch gemäß einem Kommunikationsprotokolls mit einem Datenspeicher und/oder dem Kommunikationsmodul der zu prüfenden Leiterplatte ermöglicht; und
- ein Testmodul;

wobei die Kommunikationsschnittstelle innerhalb des Gehäuses beweglich in zumindest zwei Raumrichtungen angeordnet ist, und dass die Kommunikationsschnittstelle fest oder mit einem Kabel mit dem Testmodul verbunden ist,
wobei das Testmodul einen Datenspeicher und/oder einen Kommunikationschip aufweist, auf welchem mehrere Kommunikationsprotokolle hinterlegt sind und einen Prozessor oder einen Logikbaustein zur Selektion zumindest eines Kommunikationsprotokolls,
dadurch gekennzeichnet, dass die Kommunikationsschnittstelle zumindest drei elektrisch leitende Kontaktspitzen aufweist, welche dazu eingerichtet sind das Kommunikationsmodul über geschlossene metallische Oberflächen umfassende Kontaktierungsbereiche zu kontaktieren.

Je nach Lage der zu prüfenden Leiterplatte bzw. des Prüflings oder der Prüflingsleiterplatte kann die Kommunikationsverbindung ausgerichtet werden und entweder mit Kontaktierungsbereichen auf der Leiterplatte oder in einen Kommunikationsanschluss eines Kommunikationsmodul, z.B. eine Ethernet-Buchse eingeführt werden. Die Beweglichkeit der Kommunikationsschnittstelle ermöglicht eine optimale Positionierung und Kontaktierung des Testsystems mit. der Prüflingsleiterplatte

Der Datenaustausch kann zur Prüfung des Datenaustausches durch die Prüflingsleiterplatte genutzt werden. Alternativ oder zusätzlich können auch Daten, z.B. eine Mac-Adresse oder dergleichen, vom Testsystem auf die Leiterplatte überspielt werden.

Durch die mehreren Kommunikationsprotokolle auf dem Testmodul des Testsystems können Leiterplatten mit unterschiedlichen Kommunikations-protokollen überprüft werden, wodurch die zu überprüfenden Leiterplatten bzw. zu prüfenden Leiterplatten unabhängig von den Kommunikationsprotokollen, welche auf den Leiterplatten vorgesehen sind, überprüfbar sind.

Weitere vorteilhafte Ausgestaltungen der Erfindung sind Gegenstand der Unteransprüche.

Über zumindest eine erste der drei Kontaktspitzen kann eine Datenzuführung zur zu prüfenden Leiterplatte erfolgen und über zumindest eine zweite der Kontaktspitzen kann eine Datenrückführung zur Leiterplatte erfolgen. An zumindest einer dritten der Kontaktspitzen kann ein Referenzpotential anliegen.

Die Kontaktspitzen können vorteilhaft federnd gelagert sein, derart, dass bei endständiger Krafteinwirkung die Kontaktspitzen zu einem Teilbereich in den hülsenförmigen Gehäuseabschnitt einsinken. Dadurch wird die Gefahr der mechanischen Schädigung der Kontaktierungsbereiche auf der zu prüfenden Leiterplatte, mit welchen die Kontaktspitzen kontaktieren und Daten austauschen, verringert.

Über zumindest zwei der Kontaktspitzen kann vorteilhaft eine differenzielle Datenzuführung zur zu prüfenden Leiterplatte erfolgen und über zumindest zwei weitere Kontaktspitzen kann eine differenzielle Datenrückführung zur Leiterplatte erfolgen.

Das Testmodul ist beweglich in zumindest zwei Raumrichtungen. In einer bevorzugten Ausführungsvariante ist die Kommunikationsschnittstelle in einem festen Abstand zum Testmodul angeordnet und mechanisch derart verbunden, so dass die Kommunikationsschnittstelle die Bewegungen des Testmoduls mit ausführt, sofern dieses bewegt wird.

Die Kommunikationsschnittstelle kann in einer weiter bevorzugten Variante der Erfindung in zumindest einer Raumrichtung verfahrbar gegenüber dem Testmodul angeordnet sein. Somit ist es beispielsweise möglich, mittels dem Testmodul eine Annäherung der Kontaktspitzen an die zu prüfende Leiterplatte, beispielsweise in x- und y-Richtung zu ermöglichen und mittels der Kommunikationsschnittstelle ein weitergehendes Heranfahren in z-Richtung. Es ist auch bevorzugt möglich ein durch das Testmodul eine Vorpositionierung, beispielsweise in x- y-Richtung und ggf. auch in z-Richtung, realisieren eine Feinjustierung der Position der Prüfnadeln mittels der zum Testmodul verfahrbaren Kommunikationsschnittstelle in einer oder mehrerer Raumrichtung durchzuführen. Dadurch werden lediglich Signalleitungen geringer Länge zwischen dem Testmodul und der Kommunikationsschnittstelle benötigt.

Die Kontaktspitzen sind bevorzugt und vorteilhaft aus- und einfahrbar in ein Gehäuse der Kommunikationsschnittstelle, besonders bevorzugt federnd, gelagert. So kann die Anzahl der Kontaktspitzen an die Array-Geometrie der metallischen Kontaktierungsbereiche auf der Leiterplatte angepasst werden. Überflüssige Kontaktspitzen werden eingefahren und schädigen nicht die Oberfläche der Leiterplatte. Die Verfahrbarkeit der Kontaktspitzen kann beispielsweise durch Federkraft-Magnetsysteme, Elektromotoren oder federgelagerte mechanische Rastsysteme, Kugelschreiber-Rastsysteme, gewährleistet sein.

Das Testmodul kann eine Sensorvorrichtung, insbesondere eine Kamera oder einen Barcodescanner, zur Erkennung eines Erkennungsmerkmals der Leiterplatte, insbesondere eines Barcodes, eines QR-Codes oder Seriennummer, aufweisen. Anhand des Erkennungsmerkmals kann durch das Testsystem erkannt werden, welches Kommunikationsprotokoll auf der Leiterplatte vorliegt und das Kommunikationsprotokoll oder die Anzahl der kontaktierenden ausgefahrenen Kontaktspitze kann aufgrund der Erkennung beispielsweise auf die Geometrie einer Arrayanordnung aus metallischen Kontaktierungsbereichen auf der zu prüfenden Leiterplatte vorausgewählt bzw. eingestellt werden.

Das Testsystem weist vorteilhaft eine Strom- und/oder Spannungsquelle zur Energieversorgung der zu prüfenden Leiterplatte über die Kommunikationsschnittstelle auf, wobei die Strom- und/oder Spannungsquelle beweglich in zumindest zwei Raumrichtungen innerhalb des Gehäuses des Testsystems angeordnet ist. Die Strom- und/oder Spannungsquelle kann auch eine Regelcharakteristik aufweisen.

Das Testsystem weist vorzugsweise eine oder mehrere stiftartige Prüfspitzen auf, welche die Leiterplatte auf einer Oberseite der zu prüfenden Leiterplatte zur Prüfung der Lotverbindung zwischen der zu prüfenden Leiterplatte und den auf der Leiterplatte angeordneten Bauteilen abtasten, mit welchen die zu prüfende Leiterplatte bestückt ist.

Die Prüfspitzen können vorteilhaft Gelenke und/oder bewegliche Achsen aufweisen und in mehrere Richtungen beweglich, insbesondere verfahrbar, im Gehäuse des Testsystems angeordnet sein.

Das Testmodul und die Kommunikationsschnittstelle können von einer Unterseite der zu prüfenden Leiterplatte heranführbar gelagert sein.

Das Testmodul kann eine oder mehrere Prüfspitzen zur Prüfung der elektrischen Verbindung von Bauteilen der Leiterplatte aufweisen, welche in maximal einer Richtung aus dem Testmodul herausfahrbar gelagert sind.

Das Testmodul kann Werkzeugbauteile aufweisen zur Behandlung der Leiterplatte, insbesondere zum Entfernen von Bestückungshilfen oder zur Reparatur von elektrischen Verbindungen. Derartige Werkzeugteile können z.B. Lötwerkzeuge oder Zangenwerkzeuge sein.

Das Testmodul und/oder die Kommunikationsschnittstelle kann besonders vorteilhaft ein Transformermodul, insbesondere einen Ethernet-Converter, aufweisen, welches den Kontaktspitzen vorgeschalten ist.

Das Testmodul und/oder das Kommunikationsmodul kann eine Temperaturmesseinrichtung zur Temperaturmessung von Lötverbindungen und elektronischen Bauteilen aufweisen. Damit erfolgt eine zeiteffiziente und umfassende Überprüfung der Leiterplatte. So kann während der Überprüfung der Kommunikationsschnittstelle eine Temperaturkontrolle von Bauteilen auf der zu prüfenden Leiterplatte und ggf. auch deren Reparatur durch die vorgenannten Werkzeugbauteile erfolgen.

Das Testmodul kann vorteilhaft einen Treiber und/oder Sensor aufweisen, mit dem der Pegel der Kommunikationsprotokolle eingestellt werden kann und mit dem auch die Ströme auf den Kommunikationsleitungen gemessen und überwacht werden können.

Das Testmodul kann zudem eine Relaismatrix und/oder einen Multiplexer aufweisen, mit dem die Kommunikationsleitungen aber auch weitere Signalquellen, insbesondere Signalquellen aus dem Testsystem und/oder einem daran angeschlossenen Computer, und/oder Spannungssignale der Strom- und/oder Spannungsquelle und/oder ermittelte Messdaten insbesondere Messdaten der Temperaturmessung sowie Schnittstellensignale der Kommunikationseinheit auf jede beliebige Kontaktspitze der Kommunikationsschnittstelle aufgeschaltet werden kann.

Das Testmodul weist vorteilhaft eine Selbstdiagnosefunktion auf, die einzelne oder mehrere Funktionen, insbesondere die Funktionsfähigkeit der Relaismatrix und/oder des Multiplexers, des Sensors und/oder des Treibers eines zweiten Multiplexers, des Kommunikationschip, der Steuereinheit, sowie der Strom- und/oder Spannungsquelle prüft und das Ergebnis an das Testsystem melden kann.

Das Testmodul kann vorteilhaft ein Transformermodul mit einem Übertrager aufweist, mit dem eine galvanische Trennung zum Kommunikationsmodul auf der zu prüfenden Leiterplatte realisiert wird und eine Anpassung im Sinne einer Ethernet Verbindung sicherstellt, insbesondere unabhängig davon, ob mit dem Kommunikationsmodul eine weitere elektrische Verbindung zu einer Ethernet Buchse besteht oder nicht.

Nachfolgend wird die Erfindung anhand mehrerer Ausführungsbeispiele und unter Zuhilfenahme der beiliegenden Figuren näher erläutert. Es zeigen:
Fig. 1 schematische Darstellung bezüglich eines erfindungsgemäßen achsengesteuerten Testsystems zur Prüfung von elektronischen Leiterplatten;
Fig. 2 schematische Darstellung eines Testmoduls als Teil des erfindungsgemäßen Testsystems;
Fig. 3 schematische Darstellung einer Produktionsstrecke zur Herstellung einer Leiterplatte mit einem in der Produktionsstrecke integrierten erfindungsgemäßen Testsystem 1
Fig. 4 schematische Darstellung einer ersten Variante einer Kommunikationsschnittstelle als Teil des erfindungsgemäßen Testsystems;
Fig. 5 schematische Darstellung einer zweiten Variante einer Kommunikationsschnittstelle als Teil des erfindungsgemäßen Testsystems;
Fig. 6a schematische Darstellung einer Kontaktierungs-Anordnung einer Leiterplatte zum Datenaustausch mit einer Kommunikationsschnittstelle eines Testsystems;
Fig. 6b schematische Darstellung einer Haltevorrichtung zum Aus- und Einfahren von Kontaktspitzen der Kommunikationsschnittstelle;
Fig. 7 schematische Darstellung einer zweiten Kontaktierungs-Anordnung auf einer Leiterplatte zum Datenaustausch mit einer Kommunikationsschnittstelle eines Testsystems;
Fig. 8 schematische Unteransicht der zweiten Variante einer Kommunikationsschnittstelle des erfindungsgemäßen Testsystems, gemäß Fig. 5;
Fig. 9 Schaltplan einer Anordnung mehrerer Bauteile eines Testmoduls mit Kommunikationsschnittstelle des erfindungsgemäßen Testsystems;
Fig. 10 schematische Darstellung eines Schaltbildes einer LDO-Spannungsquelle mit dem Testmodul;
Fig. 11 schematische Darstellung eines Transformermoduls für eine Ethernet Kommunikation;
Fig. 12 schematische Darstellung einer rotierenden Kommunikations-schnittstelle;
Fig. 13 schematische Darstellung einer Realisierung mit unterschiedlichen Kommun ikationsprotokolle

Testsysteme zur Prüfung von elektronischen Leiterplatten sind an sich bekannt. Sie dienen der Prüfung der Funktionsweise einzelner Elektronik-Bauteile, welche auf der Leiterplatte angeordnet und mit dieser verlötet sind. Weiterhin dient ein entsprechendes Testsystem der Prüfung der elektrischen Verbindungen der Elektronikbauteile bzw. der Elektronikkomponenten untereinander und mit den Leiterbahnen der Leiterplatte.

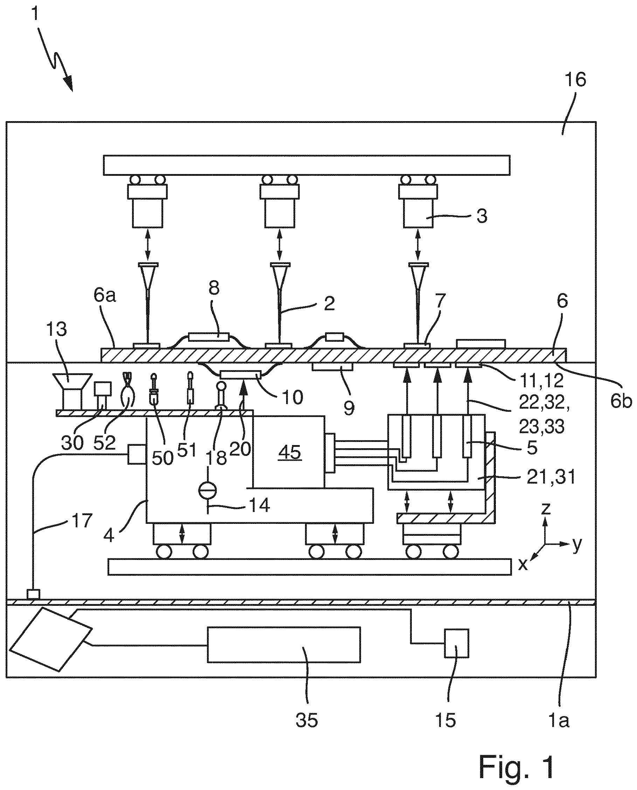

Figur 1 zeigt ein erfindungsgemäßes Testsystem 1 zum Testen von elektronischen Leiterplatten, wobei eine jeweilige zu prüfende Leiterplatte 6 eine Anzahl von integrierten Schaltungen 8 auf der Oberseite 6a der Leiterplatte 6 aufweist.

Oberhalb der zu prüfenden Leiterplatte werden durch das Testsystem 1 zumindest eine stiftartige Prüfspitze 2, vorzugsweise mehrere stiftartige Prüfspitzen 2, herangeführt. Diese Prüfspitzen können vorzugsweise als Elektroden ausgebildet sein. Das Heranführen der Prüfspitze oder Prüfspitzen kann beispielsweise durch Roboterarme 3 erfolgen, die oberhalb der zu prüfenden Leiterplatte 6 frei in x-, y- und z-Ebene, z.B. durch verfahrbare Teleskoparme oder durch x-, y- und z- linearmotorisierte Gelenkarme, beweglich zu Kontaktpunkten 7 der Leiterplatte hin- oder weggeführt werden. An diesen Kontaktpunkten 7 können Widerstandswerte ermittelt werden.

Die Roboterarme 3 können beispielsweise als lineargeführte Schlitten ausgebildet sein welcher eines oder mehrere Gelenke aufweist, so dass die stiftartigen Prüfspitzen 2 an die Leiterplatte von oben oder von mehreren Achsen heranführbar sind.

Unterhalb der zu prüfenden Leiterplatte 6 ist ein Testmodul 4 angeordnet, welche Teil des Testsystems 1 ist und zu einer Unterseite 6b der Leiterplatte 6 hin verfahrbar ist. Das Testmodul 4 ist somit analog verfahrbar in x-, y- und z-Richtung beweglich gegenüber der Leiterplatte 6 angeordnet. Dies wird z.B. in x und y-Richtung durch Linearführung, z.B. durch lineargeführte Gleitschienen bzw. sogenannte Lineartische, ermöglicht. Dies kann insbesondere durch eine Rollen-, Ketten- oder Seilzugführung erfolgen. Diese x- und y - Linearführung ist sodann in z-Richtung also senkrecht zur Platinenebene der Leiterplatte 6 durch einen Roboterarm oder einen weitere Linearführung bewegbar.

Alternativ dazu kann auch die Leiterplatte 6 beweglich gegenüber dem Testmodul 4 und/oder der stiftartigen Prüfspitzen 2 angeordnet sein. In diesem Fall weist das Testsystem 1 eine Halterung auf, welche zumindest in x- und in y-Richtung, ggf. auch in z-Richtung beweglich, z.B. durch einen höhenverstellbaren Lineartisch, beweglich gelagert ist.

Das Testmodul 4 kann somit von unten an die Leiterplatte 6 herangeführt werden. Anders als die von oben herangeführten einzelnen Prüfnadeln, welche die elektrische Anbindung der Elektronikbauteile mit der Leiterplatte 6 prüfen, übernimmt das Testmodul eine Prüfung des Funktionstests, z.B. die Datenübertragung eines Kommunikationsmoduls 9 der Leiterplatte 6.

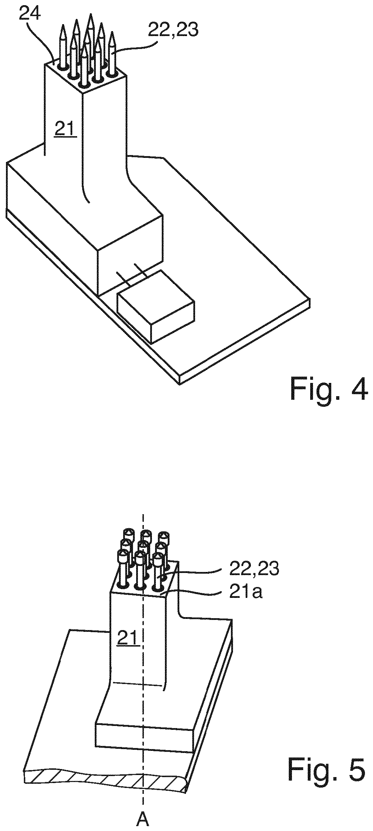

Das Testmodul 4 weist eine Kommunikationsschnittstelle 5 auf, zur Kommunikation mit dem Kommunikationsmodul 9 der zu prüfenden Leiterplatte 6. Mittels der Kommunikationsschnittstelle 5 kann durch das Testsystem 1 eine Programmierung eines auf der zu prüfenden Leiterplatte 6 angeordneten Datenspeichers 10 erfolgen. Das Testsystem kann auf diese Weise Daten auf den Datenspeicher beispielsweise eine Seriennummer, eine IP/Mac-Adresse, sowie werksseitig vorgegebene Abgleich-Einzelwerte und/oder Datensätze hinterlegen. Zwei bevorzugte Varianten einer Kommunikationsschnittstelle 5 sind in Fig. 4 und in Fig. 5 dargestellt.

Die Kommunikationsschnittstelle 5 weist in Fig. 4 vorzugsweise einen Gehäuseabschnitt 21 und mehrere Kontaktspitzen 22 auf, die in Form einer Array-Anordnung 23 aus einer Stirnfläche 24 des Gehäuseabschnitts 21 hervorstehen. Die Kontaktspitzen 22 der Array-Anordnung 23 sind in einer rechteckigen Anordnung mit insgesamt neun Kontaktspitzen angeordnet. Der Gehäuseabschnitt 21 setzt auf einer Platine auf, welche das Testmodul 4 sein kann oder eine vom Testmodul 4 abgesetzte Platine, welche jedoch über Datenleitungen sowie Energieversorgungsleitungen und vorzugsweise auch über eine feste mechanische Verbindung mit dem Testmodul 4 verbunden ist.

Dadurch die Energieversorgung und die Datenleitung der Kommunikationsschnittstelle in einer bevorzugten Variante der Erfindung direkt durch das Testmodul 4 und den darauf angeordneten oder damit verbundenen Bauteilen erfolgt, werden lange Datenübertragungswege vermieden und die Signalqualität beim Datentransfer als auch die Übertragungsgeschwindigkeit kann erhöht werden.

Die Array-Anordnung 23 dient der Kontaktierung des Kommunikationsmoduls 9 auf der zu prüfenden Leiterplatte. Dabei weist die Leiterplatte 9 metallische Kontaktierungsbereiche 11 auf. Die Kontaktierungsbereiche 11 sind punktförmige oder rechteckige Segmente, welche voneinander beabstandet sind und die gleiche Anordnung wie die Kontaktspitzen 22 der Array-Anordnung 23 aufweisen.

Die Kontaktspitzen 22 sind im Gehäuseabschnitt federgelagert, so dass sie bei Kontaktierung mit den Kontaktierungsbereichen 11 der Leiterplatte 6 zu einem Teil in den Gehäuseabschnitt 21 einfahren. Durch die Nachgiebigkeit bzw. die Ein- und Ausfahrbarkeit der Kontaktspitzen 22 in den Gehäuseabschnitt kann ein Verbiegen der Kontaktspitzen 22 und eine Schädigung der Kontaktierungsbereiche 11 der Leiterplatte 6 verhindert werden. Die Kontaktspitzen 22 können über zumindest ein Feststellelement in einer Einfahrposition gehalten werden, in welcher eine Feder, mit welcher die federgelagerte Kontaktspitze 22 zusammenwirkt, zusammengedrückt und folglich gespannt ist. So ist es möglich die Arrayanordnung, also die Anzahl an vollausgefahrenen Kontaktspitzen, zu verändern und somit an die Anzahl der Kontaktierungsbereiche 11 der Leiterplatte anzupassen. Sofern mehr Kontaktspitzen 22 als korrespondierende Kontaktierungsbereiche 11 zur Verfügung stehen, so würden starrhervorstehende, also nicht-federnd gelagerte Kontaktspitzen auf einer ungeschützten Oberfläche der Leiterplatte aufliegen, wodurch es zu einer Schädigung sowohl zur Schädigung der Kontaktspitzen 22 als auch zu einem Zerkratzen der Leiterplatte kommen kann. Dies wird durch die feststellbare Ein- und Ausfahrbarkeit einzelner Kontaktspitzen 22 aus oder in den Gehäuseabschnitt 21 vorteilhaft verhindert.

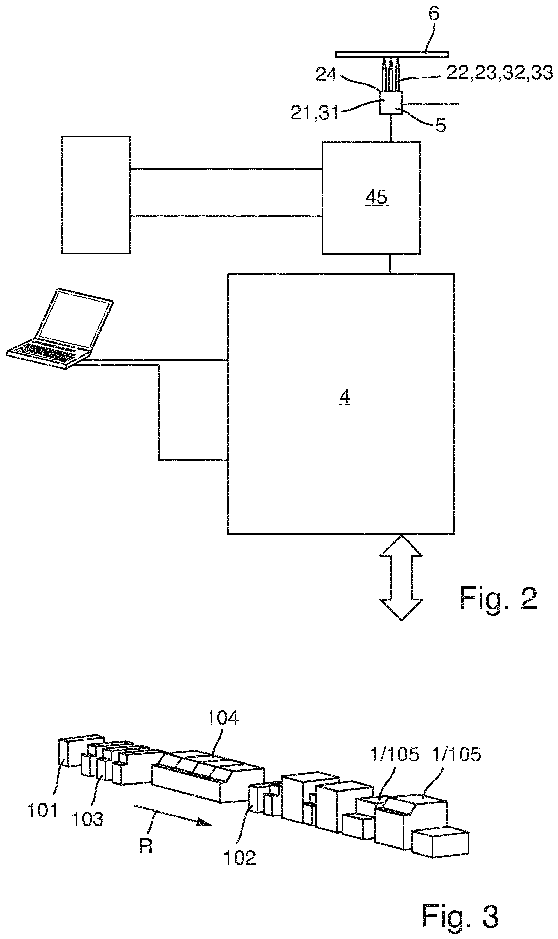

Fig. 2 zeigt schematisiert ein vorgenanntes Testmodul 4 in Verbindung mit der Kommunikationsschnittstelle 5. Dieses Testmodul 4 wird vorzugsweise zur Kommunikation vom Testsystem 1 beispielsweise in Verbindung mit einem Computer mit zur prüfenden Leiterplatte 6 eingesetzt. Zusätzlich kann es aber auch nützlich sein, über das Kommunikationsmodul 5 Messdaten von der zu prüfenden Leiterplatte abzugreifen und an die Messelektronik des Testsystems weiterzuleiten. Dies geschieht über Umschaltkontakte auf dem Testmodul 4.

Diese Umschaltkontakte ermöglichen den Einsatz des Testmoduls 4 zur Kommunikation, zur Weiterleitung der Messdaten oder ein gemischter Betrieb.

Über das Transformermodul 45, welches unter anderem auch Umschaltkontakte besitzt, können noch zusätzliche Datenquellen über das Kommunikationsmodul 5 direkt mit der zu prüfenden Leiterplatte 6 verbunden werden. Kontrollsignale, die vorzugsweise aus dem Testsystem 1 kommen, steuern beispielsweise die Umschaltung von Relais auf dem Transformermodul 45.

Die Kommunikationsschnittstelle 5 der Fig. 5 weist vorzugsweise ebenfalls einen Gehäuseabschnitt 31 und mehrere Kontaktspitzen 32 die in einer Array-Anordnung 33 an. In der Mitte ist ein Zapfen 34 angeordnet, welcher federgelagert ist und bei Kontakt mit der Leiterplatte um einen vorbestimmten Abstand in den Gehäuseabschnitt 31 einsinkt. Dadurch wird verhindert, dass eine Schädigung der Leiterplatte 6 oder eine Schädigung der Kontaktspitzen beim Aufsetzen der Array-Anordnung 33 auf der Leiterplatte 6.

Ein Array-Anordnung 23 oder 33 wird im Rahmen der Erfindung eine Anordnung aus mehreren Kontaktspitzen 22 oder 32 bezeichnet, welche in einem feststehenden und definierten Abstand zueinander auf einer Leiterplatte 6 aufsetzen und einen Datenaustausch an Kontaktpunkten vornehmen.

Dabei werden im einfachsten Fall drei Kontaktspitzen eingesetzt. Hiermit kann bereits eine Datenübertragung ermöglicht werden nach dem sogenannten SPI-Bussystem (Serial Peripheral Interface). Dabei wird eine erste Kontaktspitze 22 oder 32 benötigt zur Datenhinführung, eine zweite Kontaktspitze 22 oder 32 zur Datenrückführung und eine dritte Kontaktspitze 22 oder 32 für ein Referenzpotential.

Durch Ergänzen weiterer Kontaktspitzen können weitere Funktionalitäten ergänzt werden. So kann ein weiteres Referenzpotential abgegriffen werden. Es kann auch eine galvanische Trennung ermöglicht werden. Es kann eine Spannungsversorgung der Leiterplatte mit einer oder mehreren Spannungen erfolgen. Es kann weiterhin eine oder mehrere Simulationen durchgeführt werden, z.B. durch Übertragung eines Steuerbefehls durch eine Kontaktspitze 22 oder 32. Weiterhin kann eine Messwertprüfung eines Bauteils der Leiterplatte 6 durch eine Kontaktspitze 22 oder 32 erfolgen als Antwort auf den übermittelten Steuerbefehl. Eine weitere Kontaktspitze 22 oder 32 kann als Indikationsleitung zur Prüfung der Betriebsbereitschaft der Bauteile der Leiterplatte 6 dienen.

Durch die Kommunikationsschnittstelle 5 kann durch Kontaktieren mit den Kontaktierungsbereichen 11 der Leiterplatte 6 die Ethernetverbindung der Leiterplatte vor dem Kommunikationsmodul für die Ethernetverbindung prüft werden.

Besonders bevorzugt beträgt die Anzahl der Kontaktspitzen 22 oder 32 pro Array-Anordnung 23 oder 33 neun oder zehn.

Die vorbeschriebenen Varianten einer Kommunikationsschnittstelle haben den besonderen Vorteil, dass sie vom Testmodul 4 direkt positioniert werden können und ausgehend von der Testmodul 4 kurze Signal- und Energieversorgungsleitungen zur Kommunikationsschnittstelle 5 aufweisen. Dadurch wird ein Datenverlust durch lange Übertragungswege verhindert und auch eine exakte Signalerzeugung und ein Signalempfang durch die Kommunikationsschnittstelle 5 erreicht.

Die Kontaktierungsbereiche 11 stellen das Gegenstück zur Arrayanordnung 22 oder 32 der Kommunikationsschnittstelle 5 dar. Die Kontaktierungsbereiche 11 können unterschiedliche Formen, z.B. rund oder viereckig, aufweisen. Sie sind eine geschlossene metallische Oberfläche. Eine Mehrzahl an Kontaktierungsbereichen 11, z.B. neun Kontaktierungsbereiche 11, bilden eine Kontaktierungs-Anordnung 12 auf. Die Kontaktierungsbereiche der Kontaktierungs-Anordnung 12 sind in Form eines Musters voneinander beabstandet. Diese Abstände eines Kontaktierungsbereichs 11 sind zu jedem benachbarten Kontaktierungsbereich bevorzugt stets gleich angeordnet. Die Kontaktierungsbereiche sind frei von anderen Bauteilen und/oder Lötstopplack oder anderen Beschichtungen, welche die Datenverbindung stören könnten.

Die Kontaktierungsbereiche 11 der Kontaktierungs-Anordnung 12 der Leiterplatte 9 sind vorzugsweise in einem kreisförmigen Muster, vorzugsweise auf zumindest zwei oder mehr Kreisbahnen angeordnet oder ebenfalls bevorzugt in einem rechteckigen Muster, vorzugsweise quadratisch, auf der Leiterplatte 6 angeordnet.

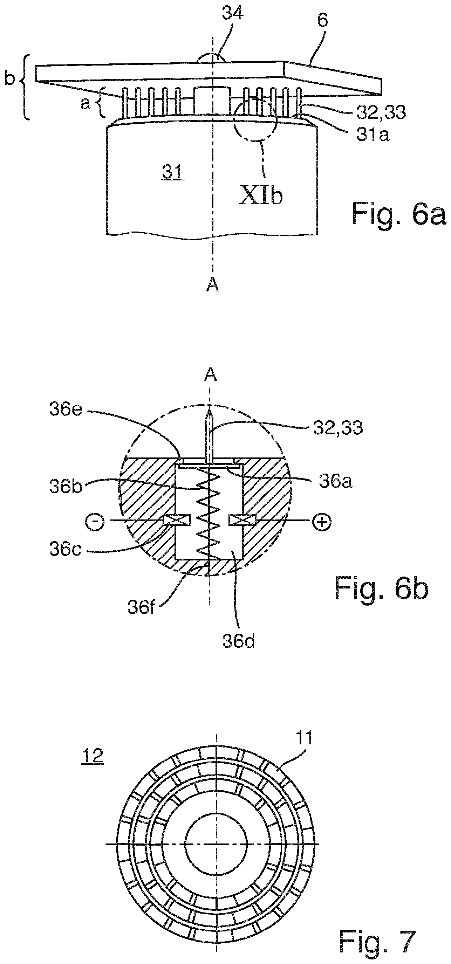

Entsprechende Muster sind in Fig. 6a, 6b und 7 dargestellt.

In Fig. 6b ist im Detail eine Haltevorrichtung 36 einer Kontaktspitze gezeigt. Dadurch ist es möglich Kontaktspitzen aus dem Gehäuse der Kommunikationsschnittstelle aus- und einzufahren. Die in Fig. 6b dargestellte Haltevorrichtung ist dabei nur eine von mehreren Varianten eine Kontaktspitze in einer Einfahrposition im Gehäuse zu halten. Dabei umfasst die Kontaktspitze 32 eine tellerförmige Ausformung 36a. Diese wird ist in einem Kanal 36d beweglich gelagert. Eine Feder 36b drückt gegen die Ausformung 36 a deren Bewegung durch einen Anschlag 36e, welcher in den Kanal hineinragt begrenzt wird. Zum Halten in Einfahrposition ist ein Elektromagnet 36c vorgesehen, welcher den Teller der Kontaktspitze bei Aktivierung des Elektromagneten anzieht. Sofern der Elektromagnet 36c nicht aktiviert wird ist die Kontaktspitze ausschließlich federgelagert. Von der Kontaktspitze geht ein Kabel 36f ab, welches zur Signal- und/oder Energieübertragung dient. Die Haltevorrichtung ist nicht auf Fig. 6a begrenzt sondern kann auch für alle anderen Varianten von vorbeschriebenen Kommunikationsschnittstellen verwendet werden.

Die Kontaktierungsbereiche 11 sind bevorzugt vergoldet oder verzinnt, um eine bessere Datenleitung zwischen

Eine entsprechende Kontaktierungs-Anordnung 12 ist vorzugsweise in der Nähe des Kommunikationsmoduls 9 der Leiterplatte 6 auf dem Kommunikationspfad angeordnet, so dass die Kommunikation der einzelnen Bauteile der Leiterplatten und ein Aufspielen von Daten z.B. auf den Datenspeicher der Leiterplatte unter Umgehung des Kommunikationsmoduls 9, also z.B. der Ethernet-Buchse, erfolgen kann.

Eine zu prüfende Leiterplatte 6 mit einem Kommunikationsmodul, welches als Ethernet-Schnittstelle ausgebildet ist kann bei einer Prüfung auf nicht-erfindungsgemäße Weise durch ein beliebiges Testsystem über eine Standard-Ethernet-Buchse mit einer Kommunikationsschnittstelle des Testsystems kontaktiert werden.

Im Rahmen der vorliegenden Erfindung wird jedoch vorgeschlagen, dass eine solche Prüfung automatisiert erfolgt, wobei die Steckverbindung über eine Ethernet-Standardbuchse für diesen Zweck sich als aufwendig erwiesen hat. Eine automatisierte Prüfung einer solchen Ethernet-Schnittstelle wird durch etablierte Firmen, welche automatisierte Testsysteme, z.B. zur Prüfung von Lötkontakten, entwickeln bislang nicht angeboten.

Die Kommunikationsschnittstelle 5 kann bevorzugt eines oder mehrere Bauteile aufweisen, welche den Bauteilen des Kommunikationsmoduls 9 der Leiterplatte 6 nachgebildet sind. Dieses Bauteil ist in Fig. 4 und 5 in dem Gehäuseabschnitt 21 oder 31 angeordnet und kann beispielsweise als Transformermodul 45, auch Umwandler genannt, ausgebildet sein. Ein solches Transformermodul kann vorzugsweise ein sogenannter Ethernet Magnetic Transformer sein, Ein entsprechendes Transformermodul ist zumeist auch in einem Ethernet-Stecker integriert, welcher jedoch durch Kontaktierung des der Kommunikationsschnittstelle 5 mit Kontaktbereichen 11 einer Kontaktierungsanordnung 12 auf der Leiterplatte 6 umgangen werden kann.

Somit kann das Kommunikationsmodul mit den Bauteilen ohne großen Signalverlust vor und nach der Transformation aufgrund langer Datenleitungen über die Arrayanordnung 23, 33 mit der Leiterplatte 6 verbunden werden und Daten austauschen.

Durch die funktionsgleiche Nachbildung der Bauteile des Kommunikationsmoduls 9 der Leiterplatte durch die Bauteile der Kommunikationsschnittstelle 5 des Testmoduls 4 kann eine sichere Kommunikation mit der Prozessoreinheit, dem Datenspeicher und weiteren Bauteilen auf der zu prüfenden Leiterplatte 6 gewährleistet werden, ohne dass es darauf ankommt ob die überbrückte Ethernet-Buchse der Leiterplatte 6 kein Transformermodul, ein Transformermodul oder mehrere Transformermodule in Serie oder Parallel zueinander verschaltet aufweist.

Nach dem Auslesen des Typs der Ethernet-Buchse auf der Leiterplatte durch das Testsystem z.B. anhand eines Barcodes auf der Leiterplatte kann das Testsystem eine entsprechende Bauteileschaltung auswählen, welche der Verschaltung des Ethernet-Buchse entspricht, so dass ein identischer Datenaustausch zwischen dem Testsystem 1 und der Leiterplatte 6 trotz Überbrückung ermöglicht wird, so als ob das Testsystem über die Ethernet-Buchse der Leiterplatte 6 mit dieser verbunden ist.

So kann beispielsweise ein Datenaustausch bei einer typischen Datenübertragungsrate von 10 bis 100 Mbit/s erfolgen

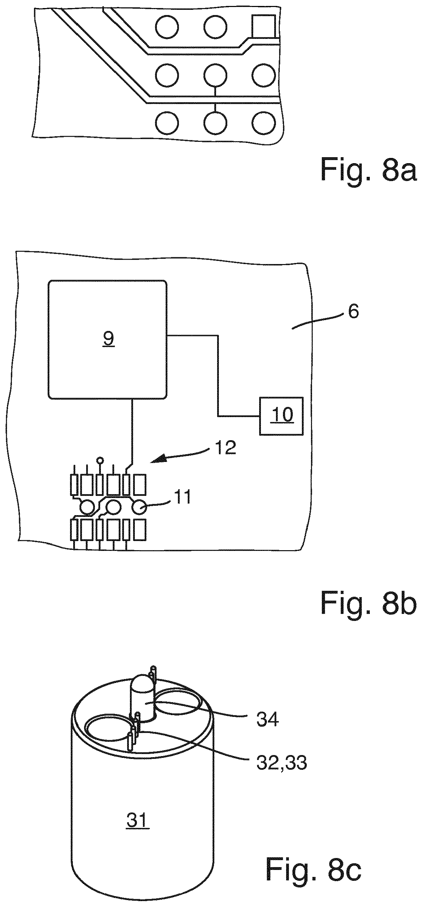

In Fig. 5 und Fig. 8 ist eine Variante einer Array-Anordnung 33 mit dem Zapfen 34 angeordnet, In diese Variante ist der Zapfen als Zentrierzapfen ausgebildet und voneinander beabstandet entlang einer radial zu diesem Zentrierzapfen verlaufenden Linie sind die Kontaktspitzen 32 angeordnet.

Die Kontaktspitzen 32 können ausfahrbar sein und beispielsweise anhand eines Feststellmechanismus bei Bedarf ausgefahren werden. So können je nach Bauteiletyp der Leiterplatte die nicht-benötigten Kontaktspitzen 32 eingefahren werden.

Der Bauteiletyp kann anhand eines auf der Leiterplatte befindlichen Barcodes identifiziert werden, welcher mittels einer auf dem Testmodul 4 befindlichen Kamera 13 identifiziert werden kann. Je nach Vorgabe des Barcodes können sodann entsprechend die Kommunikationsschnittstelle 5 und die dazugehörigen Bauteile, sowie weitere Bauteile des Testmoduls 4 bedient und insbesondere in Bereitschaft versetzt werden.

Durch die einfahrbaren Kontaktspitzen wird weniger Platz auf der zu prüfenden Leiterplatte für Kontaktbereiche 11 benötigt, so dass das Material der Leiterplatte eingespart werden kann und eine optimierte Bauteilanordnung auf der Leiterplatte gelingt.

Die Zentrierung durch den Zentrierzapfen kann insbesondere mit einer Anordnung von Kontaktbereichen 11 auf einer Leiterplatte 6 zusammenwirken, wie sie in Fig. 8 dargestellt ist.

Weiterhin ist es dabei von Vorteil, wenn die Array-Anordnung, also die Anordnung der stiftartigen metallischen Kontaktspitzen 22, 32 drehbar um eine durch den Zentrierzapfen definierte Achse angeordnet ist. So können die stiftartigen Kontaktspitzen besser die Kontaktbereiche 11 anfahren und mit diesen kontaktieren, so kann vorteilhaft die Anzahl an Kontaktbereichen 11 reduziert werden. Die Drehbarkeit der Array-Anordnung ist auch bei rechteckigen Array-Anordnungen der Kontaktspitzen, wie z.B. in Fig. 4, von Vorteil.

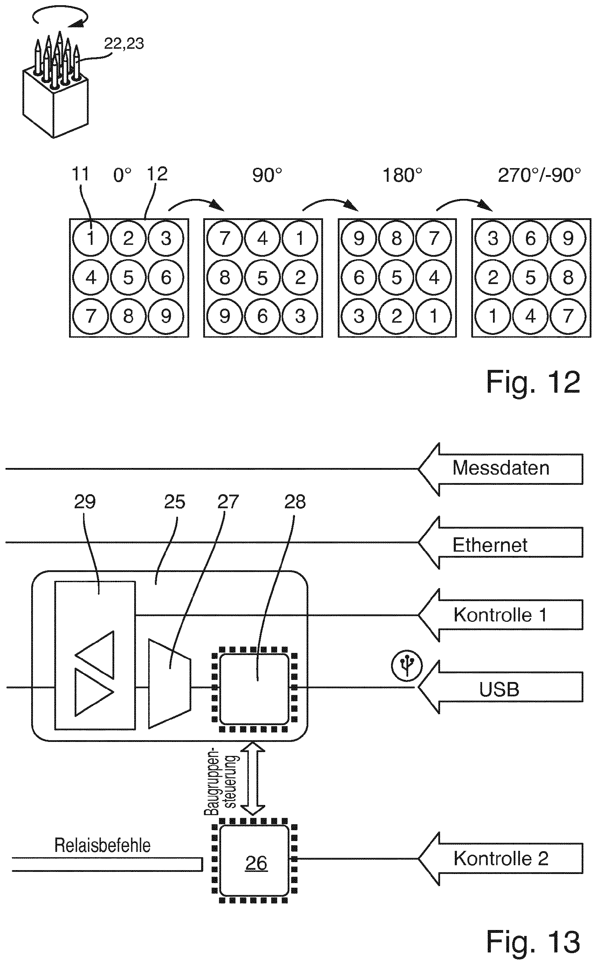

Die Rotierbarkeit der Array-Anordnung 23, 33 wie in Fig 12 und Fig 8 dargestellt ist zudem von Vorteil, da auf diese Weise Leiterplatten 6 mit unterschiedlicher Orientierung, also eine Zuführung in Längs- oder Querrichtung der Leiterplatte, zugeführt und im Testsystem 1 prüft werden können, ohne dass die Leiterplatte durch Rotation in Position gebracht werden muss. Vielmehr kann durch Rotation der Array-Anordnung 23, 33 deren Positionsspitzen 22, 32 nach der Orientierung der Leiterplatte ausgerichtet werden. Ein Verdrehen der Leiterplatte oder ein Zuführen in das Testsystem aus einer nicht-optimalen Richtung hat damit keine Folgen für den Test und das Übertragen von Daten.

Die Rotation der Arrayanordnung, z.B. durch drehbare Lagerung der Arrayanordnung, kann somit sowohl für eine rechtechige Arrayanordnung der Kontaktspitzen als auch für eine lineare Anordnung der Kontaktspitzen vorteilhaft im Rahmen der vorliegenden Erfindung realisiert werden.

Durch Hinterlegung verschiedener Datensätze kann die Testmodul 4 über unterschiedliche Kommunikationsprotokolle mit der zu prüfenden Leiterplatte 6 und den darauf befindlichen Kommunikationsmodule 9 und Datenspeicher 10 kommunizieren sowie in Fig. 13 dargestellt. So kann je nach Kommunikationsart ein individuelles Einspeisen von Kommunikationsprotokollen erfolgen und ggf. zwischen den Kommunikationsarten umgeschaltet werden. Hierfür werden keine weiteren Systeme ermöglicht sondern die Datenübertragung kann während der oberflächlichen Prüfung der Lötstellen und Elektronikbauteile erfolgen.

Dadurch können durch das Testsystem je nach Bedarf verschiedene Kommunikationsprotokolle auf zu prüfende Leiterplatte 6 angewendet werden und/oder die Leiterplatte 6 auf das Vorhandensein dieser Kommunikationsprotokolle prüft werden. Derartige Kommunikationsprotokolle sind z.B. I2C, SPI, USB, Ethernet, Profibus und/oder UART.

Die Pegel der Treiber sind dabei vorzugsweise über eine auf dem Datenspeicher oder einem Logikbaustein des Testmoduls 4 hinterlegte Software oder direkt über das Prüfsystem 1 einstellbar. Somit kann das Testmodul 4 über die Kommunikationsschnittstelle 5 nicht nur mit verschiedenen Kommunikationsprotokollen kommunizieren sondern kann auch den Spannungspegel der Kommunikationssignale auf das Niveau der zu prüfenden Leiterplatte 6 anpassen.

Weiterhin auf dem Datenspeicher oder dem Logikbaustein des Testmoduls 4 ist ein Selbstdiagnoseprogramm hinterlegt, mit welchem eine Diagnose des Testmoduls 4 und der Kommunikationsschnittstelle 5 erfolgen kann und welches von einem Prozessor oder einen Logikbaustein des Testmoduls 4 ausgeführt werden kann.

Im Rahmen der vorliegenden Erfindung wird die Kommunikationsschnittstelle 5 als ein erstes Bauteil zur Funktionsprüfung bezeichnet, mit welcher durch Senden und Empfangen von Kommunikationsdaten an die Leiterplatte 6, die korrekte Datenübertragung der Leiterplatte 6, insbesondere einer der Leiterplatte 6 zugeordneten Prozessoreinheit, welche einen Datenspeicher verwaltet, durch das Testsystem 1 prüft wird. Weitere Bauteile, welche bevorzugt im Rahmen der vorliegenden Erfindung eingesetzt werden können, werden nachfolgend beschrieben.

Die Testmodul 4 weist zumindest eines oder mehrere zweite Bauteile im Rahmen der vorliegenden Erfindung auf, welches als ein Auflageelement 18 zur Beabstandung zwischen der Leiterplatte 6 und dem Testmodul 4 und ggf. zur Stützung der Leiterplatte 6 gegen Durchbiegen dient.

Ein drittes Bauteil, welches auf dem Testmodul 4 angeordnet sein kann, ist eine Kamera 13zur Bilderfassung im sichtbaren Spektralbereich. Diese Kamera 19 kann verschiedene Funktionen erfüllen.

Sie kann zur Positionsbestimmung der zu prüfenden Leiterplatte 6 dienen.

Sie kann alternativ oder zusätzlich auch die zu prüfende Leiterplatte 6 auf Anwesenheit von Bauteilen untersuchen, mit welchen die Leiterplatte bestückt sein sollte.

Die Kamera 13 kann zudem alternativ oder zusätzlich einen Barcode oder eine Seriennummer auf der Leiterplatte 6 erfassen und die Leiterplatte gemäß diesem Barcode bestimmte Datensätze und Steuerprogramme von einem Datenspeicher abrufen und initiieren. Dies kann unter anderem spezielle Vorgaben zur Untersuchung der Leiterplatte 6, respektive der darauf angeordneten Bauteile, umfassen oder den Umfang der Daten, welche an den Datenspeicher der Leiterplatte 6 unter Zuhilfenahme der Kommunikationsschnittstelle übermittelt werden sollen.

Die Kamera 13 kann zudem eine Prüfung von Lötstellen auf Anwesenheit vornehmen.

Weitere Funktionen, beispielsweise weitere Diagnosefunktionen, können noch zusätzlich durch die Kamera ausgeführt werden.

Ein viertes Bauteil des Testmoduls 4 kann beispielsweise eine metallische stiftförmige Prüfspitze 20 z.B. zur Prüfung der unterseitig angeordneten Lötkontakte durch Widerstandsmessung umfassen, welcher jedoch anders als die Prüfspitzen 2 welche von oberhalb der Leiterplatte 6 herangeführt werden, starr mit dem Testmodul 4 oder nur in eine Richtung beweglich, insbesondere ausfahrbar, auf dem Testmodul 4 angeordnet sein kann. Dadurch verringert sich der mechanische Aufwand dieses metallischen Prüfspitze 20.

Alternativ oder zusätzlich zu mechanischen Funktionen oder Diagnosefunktionen durch das vorgenannte Bauteil oder die vorgenannten Bauteile kann auch ausschließlich ein Aufspielen von Daten z.B. von Kommunikationsprotokollen durch die Kommunikationsschnittstelle 5 erfolgen. Durch das Aufspielen der Daten auf den Datenspeicher 10 der zu prüfenden Leiterplatte 6 zeitgleich während des Prüfens der Lötverbindungen z.B. durch die Prüfspitzen 2 wird eine Zeitersparnis erzielt während die Qualitätskontrolle erfolgt.

Das Aufspielen der Daten kann beispielsweise als eine Art Basis- bzw. Grundprogrammierung erfolgen. Die zu prüfende Leiterplatte 6 kann insbesondere in einem Messgerät der Automatisierungstechnik eingesetzt werden. An den Datenspeicher 10 kann in Abhängigkeit von dem jeweiligen Messgerät, dem Einsatzgebiet des Messgerätes und der Produktionsstrecke bei der Herstellung des Messgerätes Daten übertragen werden. Die Datenübertragung kann spezifisch von der Bestückung der Leiterplatte erfolgen, so dass Daten zur Steuerung, Prüfung und/oder Identifizierung der einzelnen Bauteile oder Baugruppen der Leiterplatte 6 vom Datenspeicher des Testmoduls 4 über die Kommunikationsschnittstelle 5 und das Kommunikationsmodul 9 auf den Datenspeicher 10 der Leiterplatte überspielt werden können.

Alternativ oder zusätzlich zu den vorgenannten Bauteilen kann das Testmodul 4 auch eines oder mehrere Werkzeugbauteile 50, beispielsweise ein Lötelement 51 zur Ausbildung eines Lotes oder eine Zange 52, umfassen. Weitere Werkzeugbauteile z.B. Schraubenzieher und dergleichen können ebenfalls vorgesehen sein. Durch die Ansteuerung der Werkzeuge kann eine einfache Reparatur der zu prüfenden Leiterplatte 6 in zeitlich enger Abfolge zur Detektion eines Defekts durch die oberen Prüfspitzen 2 erfolgen oder die Entfernung von Bestückungshilfen erfolgen.

Zusätzlich kann das Testmodul 4 auch eine Strom- und/oder Spannungsquelle zur Spannungsversorgung der Werkzeugbauteile oder der Bauteile zur Funktionsprüfung aufweisen.

Das Testsystem 1 verfügt über den Datenspeicher 35 mit einem darauf abgelegten entsprechenden Testprogramm Dieses Testprogramm steuert den Einsatz des Auflagenelements 18, der Kontaktspitzen 22, der Prüfspitze 20, und/oder ggf. weiterer Werkzeuge 50, 51, 52 und deren Positionierung. Dadurch können unterschiedliche zu prüfende Leiterplatten 6 mit unterschiedlichen Abständen der Bauteile prüft und mit Daten versorgt werden.

Zusätzlich zu den oberseitig durch die Prüfspitzen 2 durchgeführten Lötstellentests erfolgt in der erfindungsgemäßen Variante der vorliegenden Erfindung ein Funktionaltest einzelner Bauteile durch das Testmodul 4.

Die vorgenannten Bauteile der Prüfplatine 4 können einzeln oder besonders bevorzugt gemeinsam auf dem Testmodul 4 angeordnet sein. Letzteres ist von Vorteil, da so ein festgelegter Abstand eingehalten wird.

Durch die Verfahrbarkeit des Testmoduls 4 unterhalb der Leiterplatte 6 in x-, y- und z-Richtung kann zeitgleich zur Qualitätskontrolle der Verbindungen der elektronischen Bauteile mit den Leitungen der Leiterplatte auch eine Funktionsprüfung der jeweiligen Bauteile der zu prüfenden Leiterplatte erfolgen, dies führt zu einer Zeitersparnis und zu einer räumlichen Ersparnis eines zusätzlichen Testsystems.

Ein weiterer Aspekt der vorliegenden Erfindung ist die Spannungs- und/oder Stromversorgung des Testmoduls 4 und der damit verbundenen Bauteile, also die Kommunikationsschnittstelle 5, sowie der zu prüfenden Leiterplatte 6, aber auch weitere Bauteile, z.B. Werkzeugelemente wie Zangen oder Lötelemente oder eine oder mehrere Kameras. Bei bislang bekannten Testsystemen erfolgt die Spannungsversorgung durch eine Strom- und/oder Spannungsquelle außerhalb des Testsystems, also räumlich entfernt von dem Prüfling bzw. der zu prüfenden Leiterplatte 6.

Gemäß dem Konzept der vorliegenden Erfindung ist die Strom- und/oder Spannungsquelle 14 Teil des Testsystems 1 und insbesondere Bestandteil des Testmoduls 4. Dadurch wird ein Spannungsabfall bedingt durch lange Leitungen 17 verhindert. Die Strom- und/oder Spannungsquelle kann durch eine Steuereinheit 15 nach einem Programm oder durch manuelle Eingabe von der Steuereinheit 15 gesteuert werden.

Das Testsystem 1 selber wird durch ein Gehäuse 16 begrenzt. Während das Testmodul 4, sowie die Kommunikationsschnittstelle 5 und die Strom- und/oder Spannungsquelle 14 beweglich im Gehäuse angeordnet ist, so ist die Steuereinheit 15 vorzugsweise starr im oder am Gehäuse 16 des Testsystems 1 oder außerhalb dieses Gehäuses 16 angeordnet.

In einer besonderen Ausführungsvariante der Erfindung sind die Kontaktspitzen 22, 32 direkt mit der Strom- und/oder Spannungsquelle 14 über eine Stromversorgungsleitung verbunden. Die Strom- und/oder Spannungsquelle 14 kann von außen, also außerhalb des Gehäuses 16 des Testsystems 1, mit Energie versorgt werden und ebenfalls von außen mit Steuerbefehlen auf einen Spannungsabgabewert eingestellt werden.

Durch die Steuereinheit 15 kann sowohl die dem Testmodul 4 und insbesondere der Kommunikationsschnittstelle 5 zugeführte Spannung oder die dem Testmodul 4 und insbesondere der Kommunikationsschnittstelle 5 zugeführte Stromstärke eingestellt werden oder sowohl die zugeführte Stromstärke als auch die zugeführte Spannung eingestellt werden. Somit können insbesondere die Kontaktspitzen 22, 32 mit einem Strom mit einer vorbestimmten Spannung und/oder einer vorbestimmten Stromstärke betrieben werden.

Als Strom- und/oder Spannungsquelle 14 wird im Rahmen der vorliegenden Erfindung ein Bauteil bezeichnet, welches aus einer größeren Spannung oder einer größeren Stromstärke unabhängig von der Größe der zugeführten Spannung oder Stromstärke einen diskreten kleineren Spannungs- und/oder Stromstärke-Wert generiert.

Zur Prüfung, welcher Spannungswert an den Kontaktspitzen 22 oder 32 ankommt, kann die Strom- und/oder Spannungsquelle 14 vorzugsweise über eine Rückleseleitung, eine sogenannte Sense-Leitung, mit den Kontaktspitzen verbunden sein. In der vorliegenden Strom- und/oder Spannungsquelle 15 wird die Ausgangsspannung oder ein Teil davon mit einer Referenzspannung verglichen und so ausgeregelt, daß auch bei schwankender Last die Ausgangsspannung auf der zu prüfenden Leiterplatte 6 konstant bleibt. Dieser Zustand liegt allerdings meist nur im idealen Fall vor. Daher wird die mit der Referenzspannung zu vergleichende Spannung in der Nähe der Last, also bei den Kontaktspitzen 22 oder 32 also hinter den Zuleitungen mit dem schwankenden Spannungsabfall mittels der Rückleseleitung ermittelt. Der Spannungsabfall auf den Zuleitungen wird dadurch mit ausgeregelt und die Spannung an der Last, also den Kontaktspitzen der Kommunikationsschnittstelle 5 bleibt auch im Realfall konstant. Die vorgenannte Leitung kann durch Parallelschaltung mit dem Spannungseingang der jeweiligen Prüfspitze erzeugt werden, so dass die Strom- und/oder Spannungsquelle 14 den Spannungsabfall des Leitungswiderstandes ausgleicht. Die von der Strom- und/oder Spannungsquelle 14 erzeugte Spannung kann folglich nach Abgleich mit den rückgelesenen Werten angepasst werden. Damit kann der Spannungsabfall durch den Leitungsweg zwischen den Kontaktspitzen 22, 32 und der Strom- und/oder Spannungsquelle 14 ausgeglichen werden und ggf. auch Spannungsschwankungen ausgeglichen werden.

Insgesamt kann die Spannungsversorgung durch die Strom- und/oder Spannungsquelle durch ein Programm, welches vorzugsweise auf dem Datenspeicher der Testmodul 4 hinterlegt ist, gesteuert werden. Eine bevorzugte Art einer programmierbaren Spannungsquelle ist auch als LDO (Low-Drop-Out Spannungsregler) bekannt und kann im Rahmen der vorliegenden Erfindung als bevorzugte Form einer Strom- und/oder Spannungsquelle 14 eingesetzt werden.

Die Strom- und/oder Spannungsquelle 14 ist so konzipiert, dass sie extrem schnell auf Laständerungen auf der zu Prüfenden Leiterplatte reagieren und ausgleichen kann, vorzugsweise im Bereich von einigen Nanosekunden. Dies wird bevorzugt benötigt, wenn es sich bei der zu Prüfenden Leiterplatte 6 um eine Bauteil mit schnellen Mikroprozessoren mit schneller Kommunikation und Speicherbausteinen handelt das diese dynamische Lastaenderungen aufweisen.

Diese Funktion wird vorzugsweise durch Bausteine mit schnellen Regeleigenschaften realisiert und /oder mit Kondensatoren welche sehr kurze Energiespitzen überbrücken können.

Die Stromstärkewerte können in einer weiteren bevorzugten Variante der Erfindung ebenfalls ausgelesen und durch Abgleich mit einem hinterlegten Datensatz begrenzt werden. Dieser Datensatz kann ebenfalls bevorzugt auf dem Datenspeicher der Testmodul 4 und/oder der Steuereinheit 15 hinterlegt sein.

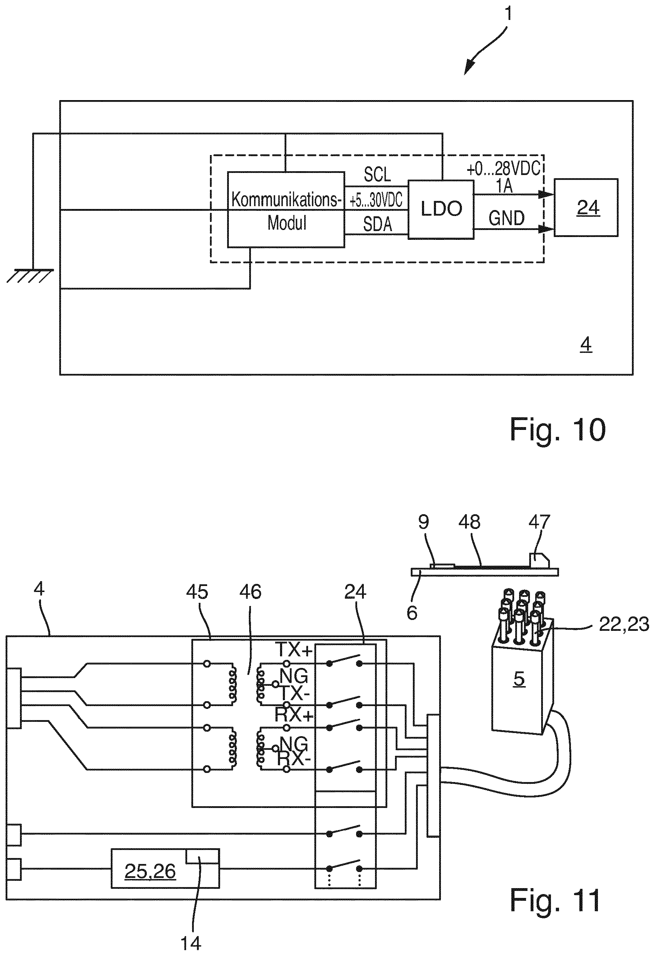

Ein Schaltbild für eine bevorzugte eingesetzte Strom- und/oder Spannungsquelle 14 ist in dem Schaltbild der Fig. 10 dargestellt. Es Zeigt:

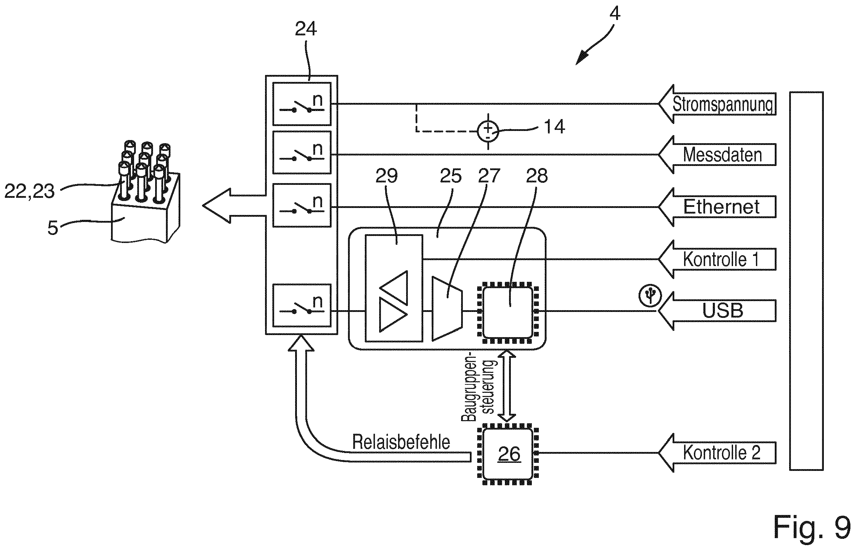

Fig. 9 zeigt die wesentlichen Bestandteile des Kommunikationsmoduls 4. Der Kern bildet die Kommunikationseinheit 25. Sie stellt die verschiedenen Kommunikationsprotokolle dar und /oder wandelt ein vom Testsystem kommendes Protokoll z.B. USB ein anderes Protokoll um. Ein Multiplexer 27 (MUX), der dem Kommunikationschip 28 nachgeschaltet ist, kann die einzelnen Kommunikationssignale auf beliebige Kontaktspitzen 2, 32 der Kommunikationsschnittstelle 5 schalten. Das wiederum bringt Flexibilität bei der Gestaltung der Kontaktpunkte 7 bzw. der Arrayanordnung 23 auf der zu prüfenden Leiterplatte 6.Dem Multiplexer 27 (MUX) kann ein Treiber/Sensor 29 nachgeschaltet sein, der die Signalpegel der Kommunikationssignale anpassen kann. Somit wird die Flexibilität der Kommunikationseinheit 25 erhöht, weil sie sich auf verschiedene Signalpegel und somit auf verschiedene Spannungstechnologien der zu prüfenden Leiterplatte 6 anpassen kann. Weiterhin kann der Treiber/Sensor 29 auch einen Sensor enthalten, der den Strom über die Kommunikationsleitungen misst und bei Abweichungen z.B. eine Fehlermeldung auslöst oder eine Abschaltung vornimmt. Die Steuerung des Kommunikationschip 28, des Multiplexer 27, des Treiber/Sensor 29 und der nachgeschalteten Relaismatrix 24 wird durch ein Logikbaustein 26 dargestellt der Wiederum mit dem Testsystem in Verbindung steht. Der Logikbaustein 26 kann durch ein FPGA, ein Mikrocomputer oder ein anderer Chip mit Logikfunktionen realisiert sein. Eine zusätzliche Relaismatrix 24 erweitert die Flexibilität des Testmoduls 4 in dem sie die Möglichkeit bietet mehrere Signalquellen, Spannungsversorgungen, Kommunikationsschnittstellen, und Messdaten sowie die Schnittstellensignale aus der Kommunikationseinheit 25 auf jede beliebige Kontaktspitze 2, 32 der Kommunikationsschnittstelle 5 zu schalten. Das trifft auch für die Strom/ Spannungsquelle 14 des Testmoduls 4 zu aber auch für Versorgungseinheiten des Testsystems 1 wie mit dem Testmodul 4 verbunden sind. Dabei ist auch eine gemischte oder kombinatorische Verschaltung vorstellbar. Die Relaismatrix 24 kann ebenfalls aus der Steuereinheit 26 angesteuert werden.

Der in Fig. 10 dargestellte LDO ist ein sogenannter Low Drop Out Spannungsregler. Das Communication Module ist ein Kommunikationsmodul welches den LDO steuert und die Verbindung zum Testsystem 1 darstellt. Das LDO kann auf dem Testmodul 4 oder dem Kommunikationsinterface 5 lokalisiert sein. Die Abbildung der Fig. 10 zeigt eine Lokalisierung auf dem Testmodul 4.

Das Transformermodul 45 ist vorzugsweise Bestandteil des Testmoduls 4 und kann über die Kommunikationsschnittstelle 5 mit einer zu prüfenden Leiterplatte 6 verbunden werden. Die zu prüfende Leiterplatte enthält ein Kommunikationsmodul 9 das vorzugsweise Ethernet oder Profinet Kommunikation unterstützt. Magnetics 46, also Übertrager oder Transformer, des Transformermoduls 45 sind derart dimensioniert, dass es eine galvanische Trennung zum Kommunikationsmodul 9 realisiert und eine elektrische Anpassung im Sinne einer Ethernetverbindung dargestellt werden kann. Zusätzlich sind die Magnetics 46 des Transformermoduls 45 so berechnet, dass eine Ethernet/Profinet Kommunikation mit 100Mbit/s möglich ist, unabhängig davon ob mit dem Kommunikationsmodul 9 über eine elektrische Verbindung 48 eine sogenannte Ethernet Buchse montiert ist oder auch nicht. Es ist ebenfalls unerheblich ob eine auf der zu prüfenden Leiterplatte 6 montierte Ethernet Buchse 47 bauartbedingt Magnetics enthält oder nicht.

Zusätzlich zu den vorbeschriebenen Bauelementen kann die Testmodul 4 auch ein Thermographiesystem, vorzugsweise in Form einer Infrarot-Kamera 130oder einen Temperatursensor, vorzugsweise einen berührungslos messender Temperatursensor, aufweisen. Die Variante des Temperatursensors ist allerdings weniger bevorzugt, aufgrund des geringem Erfassungsbereichs der Temperaturmessung. Die Infrarot-Kamera hingegen erlaubt eine Temperaturmessung einzelner Bauelemente einer zu prüfenden Leiterplatte 6 und deren Verbindung mit der Leiterplatte 6. Die Temperaturmessung der IR-Kamera kann durch die freie Positionierung der Testmodul 4 mit der IR-Kamera 30 entlang der Oberfläche der zu prüfenden Leiterplatte 6 an bestimmten bevorzugten Stellen erfolgen. Die Temperaturmessung kann bevorzugt berührungslos erfolgen. Alternativ oder zusätzlich zur Temperaturmessung durch die Infrarot-Kamera kann auch eine Prüfspitze mit einem Temperatursensor versehen durch Kontaktierung mit der Leiterplatte eine Temperaturmessung durchführen. Diese Variante benötigt allerdings einen höheren konstruktiven und steuerungsmechanischen Aufwand verbunden mit einer zeitintensiveren Messung im Vergleich zur IR-Kamera.

Fig. 3 zeigt eine Produktionsstrecke 1 zur Herstellung und Prüfung von erfindungsgemäßen Leiterplatten 6, welche vorzugsweise in Messgeräten der Automatisierungstechnik, z.B. in Messaufnehmern oder in Messwandlern, eingesetzt werden können.

Die Produktionsstrecke 1 weist eine Station 101 zur Bereitstellung eines Leiterplatten-Grundkörpers, auch Nutzen genannt, auf. Der Leiterplatten-Grundkörper kann bereits Leiterbahnen aufweisen.

Die Produktionsstrecke weist eine Transportvorrichtung 102, beispielsweise ein Förderband, auf, mit welcher der Leiterplatten-Grundkörper in Transportrichtung R von Station zu Station weitertransportiert wird.

Ausgehend von der Station 101 in welcher die Bereitstellung des Leiterplatten-Grundkörpers erfolgt, wird dieser weitertransportiert zu einer Station 103 zur Bestückung des Leiterplatten-Grundkörpers mit Elektronik-Bauteilen, wobei zumindest eine dieser Bauteile ein intelligentes Bauteil ist, welches beispielsweise als Kommunikationsmodul 9 zur Kommunikation mit anderen von der Leiterplatte abgesetzen Elektronik-Geräten ausgebildet ist. Ein weiteres intelligentes Bauteil ist eine zentrale Prozessoreinheit, die Teil der zu prüfenden Leiterplatte 6 ist und welche die Daten des Datenspeichers 10 verwaltet. Dabei wird aus dem Leiterplatten-Grundkörper die Leiterplatte 6 ausgebildet. Die Bestückung kann z.B. mit Hilfe vorher auf dem Leiterplattengrundkörper aufgebrachten Bestückungsmasken erfolgen.

Im Anschluss an die Station 103 zur Bestückung wird die Leiterplatte erfolgt ein Transport der Leiterplatte 6 in einen Lötofen 104. In diesem erfolgt eine Verlötung der Elektronik-Bauteile mit dem Leiterplatten-Grundkörper.

Nach dem Durchlauf durch den Lötofen 104 erfolgt eine Endkontrolle der fertiggestellten Leiterplatte 6 durch das Testsystem 105. Dabei erfolgt durch das Testsystem 105 eine gleichzeitige Kontrolle
a) der elektrischen Kontaktierung der Lötstellen zwischen den Bauteilen und der Leiterplatte und
b) Eine funktionale Prüfung einer oder mehrerer der intelligenten Bauteilen so z.B. des Kommunikationsmoduls 9.

Die vorgenannte funktionale Prüfung umfasst bevorzugt eine Funktionsprüfung des Kommunikationsmoduls 9, eine Programmierung und/oder eine Prüfung der Programmierung des Datenspeichers 10 der Leiterplatte 6, eine Kontrolle der Datenleitung ausgehend vom Kommunikationsmodul zur zentralen Prozessoreinheit der Leiterplatte 6.

Die komplexe Prüfung von Daten auf dem Datenspeicher, der Prozessoreinheit und des Kommunikationsmoduls kann nicht durch einzelne Prüfspitzen, wie sie von der Oberseite der Leiterplatte herangeführt werden, erfolgen. Hierfür bedarf es der vorbeschriebenen Kommunikationsschnittstelle 5 vorzugsweise mit den vorbeschriebenen Ausgestaltungen der jeweiligen Array-Anordnungen 23 oder 33 aus mehreren Kontaktspitzen 22 oder 32.

## Patentansprüche

1. Testsystem (1) zur Prüfung von elektrischen Verbindungen zwischen elektronischen Bauteilen und einer zu prüfenden Leiterplatte (6), wobei die Leiterplatte (6) ein Kommunikationsmodul (9) und Kontaktierungsbereiche (11) umfasst, umfassend:
- ein Gehäuse (1a);
- eine Kommunikationsschnittstelle (5), welche durch Kontaktierung mit der Leiterplatte (6) einen Datenaustausch gemäß einem Kommunikationsprotokolls mit einem Datenspeicher (10) und/oder dem Kommunikationsmodul (9) der zu prüfenden Leiterplatte (6) ermöglicht; und
- ein Testmodul (4);
wobei die Kommunikationsschnittstelle (5) innerhalb des Gehäuses (1a) beweglich in zumindest zwei Raumrichtungen (X,Y,Z) angeordnet ist, und
dass die Kommunikationsschnittstelle (5) fest oder mit einem Kabel mit dem Testmodul (4) verbunden ist,
wobei das Testmodul (4) einen Datenspeicher und/oder einen Kommunikationschip (28) aufweist, auf welchem mehrere Kommunikationsprotokolle hinterlegt sind und einen Prozessor oder einen Logikbaustein (26) zur Selektion zumindest eines Kommunikationsprotokolls,
**dadurch gekennzeichnet, dass** die Kommunikationsschnittstelle (5) zumindest drei elektrisch leitende Kontaktspitzen (22, 32) aufweist, welche dazu eingerichtet sind das Kommunikationsmodul (9) über geschlossene metallische Oberflächen umfassende Kontaktierungsbereiche (11) zu kontaktieren.

2. Testsystem (1) nach Anspruch 1, **dadurch gekennzeichnet, dass** über zumindest eine erste der drei Kontaktspitzen (22, 32) eine Datenzuführung zur zu prüfenden Leiterplatte (6) erfolgt und dass über zumindest eine zweite der Kontaktspitzen (22, 32) eine Datenrückführung zur Leiterplatte (6) erfolgt.

3. Testsystem (1) nach Anspruch 1-2, **dadurch gekennzeichnet, dass** an zumindest einer dritten der Kontaktspitzen (22, 32) ein Referenzpotential anliegt.

4. Testsystem (1) nach Anspruch 1, **dadurch gekennzeichnet, dass** über zumindest zwei der Kontaktspitzen (22,32) eine differenzielle Datenzuführung zur zu prüfenden Leiterplatte (6) erfolgt und dass über zumindest zwei weitere Kontaktspitzen (22,32) eine differenzielle Datenrückführung zur Leiterplatte (6) erfolgt.

5. Testsystem (1) nach einem der vorhergehenden Ansprüche, **dadurch gekennzeichnet, dass** die Kontaktspitzen (22, 32) federnd gelagert sind, derart, dass bei endständigen Krafteinwirkung die Kontaktspitzen (22, 32) zu einem Teilbereich in den hülsenförmigen Gehäuseabschnitt (21, 31) einsinken.

6. Testsystem (1) nach einem der vorhergehenden Ansprüche, **dadurch gekennzeichnet, dass** das Testmodul (4) beweglich in zumindest zwei Raumrichtungen (X,Y,Z) im Gehäuse (1a) des Testsystems (1) angeordnet ist.

7. Testsystem (1) nach einem der vorhergehenden Ansprüche, **dadurch gekennzeichnet, dass** die Kommunikationsschnittstelle (5) in einer Raumrichtung (X,Y,Z) verfahrbar gegenüber dem Testmodul (4) angeordnet ist.

8. Testsystem (1) nach einem der vorhergehenden Ansprüche, **dadurch gekennzeichnet, dass** das Testmodul (4) eine Sensorvorrichtung, insbesondere eine Kamera (13) oder einen Barcodescanner, zur Erkennung eines Erkennungsmerkmals der Leiterplatte (6), insbesondere eines Barcodes, eines QR-Codes oder Seriennummer, aufweist.

9. Testsystem (1) nach einem der vorhergehenden Ansprüche, **dadurch gekennzeichnet, dass** das Testsystem eine Strom- und/oder Spannungsquelle (14) zur Energieversorgung der zu prüfenden Leiterplatte (6) über die Kommunikationsschnittstelle (5) aufweist, wobei die Strom- und/oder Spannungsquelle (14) beweglich in zumindest zwei Raumrichtungen innerhalb des Gehäuses (1a) des Testsystems (1) angeordnet ist.

10. Testsystem (1) nach einem der vorhergehenden Ansprüche, **dadurch gekennzeichnet, dass** das Testsystem (1) einen oder mehrere stiftartige Prüfspitzen (2) welche die Leiterplatte (6) auf einer Oberseite (6a) der Leiterplatte (6) zur Prüfung der Lotverbindung zwischen der zu Leiterplatte (6) und den bestückten Bauteilen abtasten.

11. Testsystem (1) nach einem der vorhergehenden Ansprüche, **dadurch gekennzeichnet, dass** die Prüfspitzen (2) Gelenke und/oder bewegliche Achsen aufweisen und in mehrere Richtungen beweglich, insbesondere verfahrbar, im Gehäuse (1a) des Testsystems (1) angeordnet sind.

12. Testsystem (1) nach einem der vorhergehenden Ansprüche, **dadurch gekennzeichnet, dass** das Testmodul (4) und die Kommunikationsschnittstelle (5) von einer Unterseite (6b) der Leiterplatte (6) heranführbar gelagert sind.

13. Testsystem (1) nach einem der vorhergehenden Ansprüche, **dadurch gekennzeichnet, dass** das Testmodul (4) eine oder mehrere Prüfspitzen (20) zur Prüfung der elektrischen Verbindung von Bauteilen der Leiterplatte aufweisen, welche in maximal einer Richtung aus dem Testmodul (4) herausfahrbar gelagert sind.

14. Testsystem (1) nach einem der vorhergehenden Ansprüche, **dadurch gekennzeichnet, dass** das Testmodul (4) Werkzeugbauteile (50,51,52) aufweist zur Behandlung der Leiterplatte, insbesondere zum Entfernen von Bestückungshilfen oder zur Reparatur von elektrischen Verbindungen

15. Testsystem (1) nach einem der vorhergehenden Ansprüche, **dadurch gekennzeichnet, dass** das Testmodul (4) und/oder die Kommunikationsschnittstelle ein Transformermodul (45) insbesondere einen Ethernet-Converter, aufweist, welches den Kontaktspitzen (22, 32) vorgeschalten ist.

16. Testsystem (1) nach einem der vorhergehenden Ansprüche, **dadurch gekennzeichnet, dass** das Testmodul (4) und/oder das Kommunikationsmodul (5) eine Temperaturmesseinrichtung (30) zur Temperaturmessung von Lötverbindungen und elektronischen Bauteilen aufweist.

17. Testsystem (1) nach einem der vorhergehenden Ansprüche, **dadurch gekennzeichnet, dass** das Testmodul (4) einen Treiber und/oder Sensor (29) aufweist, mit dem der Pegel der Kommunikationsprotokolle eingestellt werden kann und mit dem auch die Ströme und/oder Spannungen auf den Kommunikationsleitungen gemessen und überwacht werden können.

18. Testsystem (1) nach einem der vorhergehenden Ansprüche, **dadurch gekennzeichnet, dass** das Testmodul 4 eine Relaismatrix und/oder einen Multiplexer (24) aufweist, mit dem die Kommunikationsleitungen aber auch weitere Signalquellen, insbesondere Signalquellen aus dem Testsystem (1) und/oder einem daran angeschlossenen Computer, und/oder Spannungssignale der Strom- und/oder Spannungsquelle und/oder ermittelte Messdaten insbesondere Messdaten der Temperaturmessung (30) sowie Schnittstellensignale der Kommunikationseinheit (25) auf jede beliebige Kontaktspitzen (22,32) der Kommunikationsschnittstelle (5) aufgeschaltet werden kann.

19. Testsystem (1) nach einem der vorhergehenden Ansprüche, **dadurch gekennzeichnet, dass** das Testmodul (4) eine Selbstdiagnosefunktion aufweist, die einzelne oder mehrere Funktionen, insbesondere die Funktionsfähigkeit der Relaismatrix und/oder des Multiplexers (24), eines Sensors und/oder eines Treibers (29) eines zweiten Multiplexers (27), des Kommunikationschip (28), der Steuereinheit (26) sowie der Strom- und/oder Spannungsquelle (14) prüft und das Ergebnis an das Testsystem (1) melden kann.

20. Testsystem (1) nach einem der vorhergehenden Ansprüche **dadurch gekennzeichnet, dass** das Testmodul (4) ein Transformermodul (45) mit einem Übertrager (46) aufweist, mit dem eine galvanische Trennung zum Kommunikationsmodul (9) auf der zu prüfenden Leiterplatte (6) realisiert wird und eine Anpassung im Sinne einer Ethernet Verbindung sicherstellt insbesondere unabhängig davon, ob mit dem Kommunikationsmodul (9) eine weitere elektrische Verbindung zu einer Ethernet-Buchse besteht oder nicht.

## Claims

1. A test system (1) for testing electrical connections between electronic components and a printed circuit board (6) to be tested, the printed circuit board (6) comprising a communication module (9) and contacting areas (11), comprising:
- a housing (1a);
- a communication interface (5) which, by making contact with the printed circuit board (6), enables data to be exchanged with a data memory (10) and/or the communication module (9) of the printed circuit board (6) to be tested in accordance with a communication protocol; and
- a test module (4);
wherein the communication interface (5) is arranged within the housing (1a) movably in at least two spatial directions (X, Y, Z), and
that the communication interface (5) is permanently connected or connected to the test module (4) with a cable,
wherein the test module (4) has a data memory and/or a communication chip (28), on which several communication protocols are stored, and a processor or a logic module (26) for selecting at least one communication protocol,
**characterized in that** the communication interface (5) has at least three electrically conductive contact tips (22, 32) which are set up to contact the communication module (9) via contacting areas (11) comprising closed metallic surfaces .

2. Test system (1) according to claim 1, **characterized in that** data is fed to the printed circuit board (6) to be tested via at least a first of the three contact tips (22, 32) and **in that** data is fed back to the printed circuit board (6) via at least a second of the contact tips (22, 32).

3. Test system (1) according to claim 1-2, **characterized in that** a reference potential is applied to at least a third of the contact tips (22, 32).

4. Test system (1) according to claim 1, **characterized in that** a differential data feed to the printed circuit board (6) to be tested takes place via at least two of the contact tips (22, 32) and that a differential data feedback to the printed circuit board (6) takes place via at least two further contact tips (22, 32).

5. Test system (1) according to one of the preceding claims, **characterized in that** the contact tips (22, 32) are resiliently mounted in such a way that when a terminal force is applied, the contact tips (22, 32) sink into the sleeve-shaped housing section (21, 31) to a partial extent.

6. Test system (1) according to one of the preceding claims, **characterized in that** the test module (4) is arranged movably in at least two spatial directions (X, Y, Z) in the housing (1a) of the test system (1).

7. Test system (1) according to one of the preceding claims, **characterized in that** the communication interface (5) is arranged so as to be movable in a spatial direction (X, Y, Z) relative to the test module (4).

8. Test system (1) according to one of the preceding claims, **characterized in that** the test module (4) has a sensor device, in particular a camera (13) or a barcode scanner, for detecting an identification feature of the printed circuit board (6), in particular a barcode, a QR code or serial number.

9. Test system (1) according to one of the preceding claims, **characterized in that** the test system has a current and/or voltage source (14) for supplying power to the printed circuit board (6) to be tested via the communication interface (5), the current and/or voltage source (14) being arranged movably in at least two spatial directions within the housing (1 a) of the test system (1).

10. Test system (1) according to one of the preceding claims, **characterized in that** the test system (1) comprises one or more pin-like test probes (2) which scan the printed circuit board (6) on an upper side (6a) of the printed circuit board (6) for testing the solder connection between the printed circuit board (6) to be assembled and the assembled components.

11. Test system (1) according to one of the preceding claims, **characterized in that** the test probes (2) have joints and/or movable axes and are arranged in the housing (1a) of the test system (1) so as to be movable in several directions, in particular movable.

12. Test system (1) according to one of the preceding claims, **characterized in that** the test module (4) and the communication interface (5) are mounted such that they can be approached from an underside (6b) of the printed circuit board (6).

13. Test system (1) according to one of the preceding claims, **characterized in that** the test module (4) has one or more test probes (20) for testing the electrical connection of components of the printed circuit board, which are mounted such that they can be moved out of the test module (4) in at most one direction.

14. Test system (1) according to one of the preceding claims, **characterized in that** the test module (4) has tool components (50, 51, 52) for handling the printed circuit board, in particular for removing mounting aids or for repairing electrical connections

15. Test system (1) according to one of the preceding claims, **characterized in that** the test module (4) and/or the communication interface has a transformer module (45), in particular an Ethernet converter, which is connected upstream of the contact tips (22, 32).

16. Test system (1) according to one of the preceding claims, **characterized in that** the test module (4) and/or the communication module (5) has a temperature measuring device (30) for measuring the temperature of solder connections and electronic components.

17. Test system (1) according to one of the preceding claims, **characterized in that** the test module (4) has a driver and/or sensor (29) with which the level of the communication protocols can be set and with which the currents and/or voltages on the communication lines can also be measured and monitored.

18. Test system (1) according to one of the preceding claims, **characterized in that** the test module 4 has a relay matrix and/or a multiplexer (24), with which the communication lines but also other signal sources, in particular signal sources from the test system (1) and/or a computer connected thereto, and/or voltage signals of the current and/or voltage source and/or determined measurement data, in particular measurement data of the temperature measurement (30) and interface signals of the communication unit (25) can be connected to any contact tips (22, 32) of the communication interface (5).

19. Test system (1) according to one of the preceding claims, **characterized in that** the test module (4) has a self-diagnosis function which tests individual or several functions, in particular the functionality of the relay matrix and/or the multiplexer (24), a sensor and/or a driver (29) of a second multiplexer (27), the communication chip (28), the control unit (26) and the current and/or voltage source (14), and can report the result to the test system (1).

20. Test system (1) according to one of the preceding claims, **characterized in that** the test module (4) has a transformer module (45) with a transformer (46), with which a galvanic isolation from the communication module (9) on the printed circuit board (6) to be tested is implemented and ensures an adaptation in the sense of an Ethernet connection, in particular regardless of whether or not there is a further electrical connection to an Ethernet socket with the communication module (9).

## Revendications

1. Système de test (1) pour tester des connexions électriques entre des composants électroniques et une carte de circuit imprimé (6) à tester, la carte de circuit imprimé (6) comprenant un module de communication (9) et des zones de contact (11), comprenant :
- un boîtier (1a) ;
- une interface de communication (5) qui, par mise en contact avec la carte de circuit imprimé (6), permet un échange de données selon un protocole de communication avec une mémoire de données (10) et/ou le module de communication (9) de la carte de circuit imprimé (6) à contrôler ; et
- un module de test (4) ;
dans lequel l'interface de communication (5) est disposée à l'intérieur du boîtier (1a) de manière mobile dans au moins deux directions spatiales (X, Y, Z), et
en ce que l'interface de communication (5) est reliée de manière fixe ou par un câble au module de test (4),
le module de test (4) présentant une mémoire de données et/ou une puce de communication (28), sur laquelle plusieurs protocoles de communication sont enregistrés, et un processeur ou un module logique (26) pour la sélection d'au moins un protocole de communication,
**caractérisé en ce que** que l'interface de communication (5) présente au moins trois pointes de contact (22, 32) conductrices d'électricité , qui sont conçues pour contacter le module de communication (9) par l'intermédiaire de zones de contact (11) comprenant des surfaces métalliques fermées .

2. Système de test (1) selon la revendication 1, **caractérisé en ce qu'**une amenée de données vers la carte de circuit imprimé (6) à tester est effectuée par au moins une première des trois pointes de contact (22, 32) et **en ce qu'**un retour de données vers la carte de circuit imprimé (6) est effectué par au moins une deuxième des pointes de contact (22, 32).

3. Système de test (1) selon la revendication 1-2, **caractérisé en ce qu'**un potentiel de référence est appliqué à au moins une troisième des pointes de contact (22, 32).

4. Système de test (1) selon la revendication 1, **caractérisé en ce que**, par l'intermédiaire d'au moins deux des pointes de contact (22, 32), on effectue une amenée de données différentielle vers la carte de circuit imprimé (6) à tester et **en ce que**, par l'intermédiaire d'au moins deux autres pointes de contact (22, 32), on effectue un retour de données différentiel vers la carte de circuit imprimé (6).

5. Système de test (1) selon l'une des revendications précédentes, **caractérisé en ce que** les pointes de contact (22, 32) sont montées de manière élastique de telle sorte que, en cas d'application d'une force en fin de course, les pointes de contact (22, 32) s'enfoncent sur une zone partielle dans la section de boîtier (21,31) en forme de douille.

6. Système de test (1) selon l'une des revendications précédentes, **caractérisé en ce que** le module de test (4) est disposé de manière mobile dans au moins deux directions spatiales (X, Y, Z) dans le boîtier (1a) du système de test (1).

7. Système de test (1) selon l'une des revendications précédentes, **caractérisé en ce que** l'interface de communication (5) est disposée de manière à pouvoir se déplacer dans une direction spatiale (X, Y, Z) par rapport au module de test (4).

8. Système de test (1) selon l'une des revendications précédentes, **caractérisé en ce que** le module de test (4) comporte un dispositif de détection, notamment une caméra (13) ou un scanner de codes à barres, pour la reconnaissance d'une caractéristique de reconnaissance de la carte à circuits imprimés (6), notamment un code à barres, un code QR ou un numéro de série.

9. Système de test (1) selon l'une des revendications précédentes, **caractérisé en ce que** le système de test comporte une source de courant et/ou de tension (14) pour alimenter en énergie la carte de circuit imprimé (6) à tester via l'interface de communication (5), la source de courant et/ou de tension (14) étant disposée de manière mobile dans au moins deux directions spatiales à l'intérieur du boîtier (1a) du système de test (1).

10. Système de test (1) selon l'une des revendications précédentes, **caractérisé en ce que** le système de test (1) comprend une ou plusieurs pointes de test (2) en forme de broche qui balayent la carte de circuit imprimé (6) sur une face supérieure (6a) de la carte de circuit imprimé (6) pour tester la soudure entre la carte de circuit imprimé (6) et les composants montés.

11. Système de test (1) selon l'une des revendications précédentes, **caractérisé en ce que** les pointes de test (2) présentent des articulations et/ou des axes mobiles et sont disposées de manière mobile dans plusieurs directions, en particulier de manière déplaçable, dans le boîtier (1a) du système de test (1).

12. Système de test (1) selon l'une des revendications précédentes, **caractérisé en ce que** le module de test (4) et l'interface de communication (5) sont montés de manière à pouvoir être approchés par une face inférieure (6b) de la carte de circuit imprimé (6).

13. Système de test (1) selon l'une des revendications précédentes, **caractérisé en ce que** le module de test (4) comporte une ou plusieurs pointes de test (20) pour le contrôle de la connexion électrique de composants de la carte de circuit imprimé, qui sont montées de manière à pouvoir être sorties du module de test (4) dans une direction au maximum.

14. Système de test (1) selon l'une des revendications précédentes, **caractérisé en ce que** le module de test (4) comporte des éléments d'outillage (50, 51, 52) pour le traitement de la carte de circuit imprimé, en particulier pour l'enlèvement d'aides à l'équipement ou pour la réparation de connexions électriques.

15. Système de test (1) selon l'une des revendications précédentes, **caractérisé en ce que** le module de test (4) et/ou l'interface de communication comporte un module transformateur (45), notamment un convertisseur Ethernet, qui est monté en amont des pointes de contact (22, 32).

16. Système de test (1) selon l'une des revendications précédentes, **caractérisé en ce que** le module de test (4) et/ou le module de communication (5) comporte un dispositif de mesure de la température (30) pour mesurer la température des joints soudés et des composants électroniques.

17. Système de test (1) selon l'une quelconque des revendications précédentes, **caractérisé en ce que** le module de test (4) comprend un pilote et/ou un capteur (29) qui permet de régler le niveau des protocoles de communication et qui permet également de mesurer et de surveiller les courants et/ou les tensions sur les lignes de communication.

18. Système de test (1) selon l'une des revendications précédentes, **caractérisé en ce que** le module de test 4 présente une matrice de relais et/ou un multiplexeur (24) avec lequel les lignes de communication mais aussi d'autres sources de signaux, en particulier des sources de signaux provenant du système de test (1) et/ou d'un ordinateur qui y est raccordé, et/ou des signaux de tension de la source de courant et/ou de tension et/ou des données de mesure déterminées, en particulier des données de mesure de la mesure de température (30) ainsi que des signaux d'interface de l'unité de communication (25), peuvent être connectés à n'importe quelle pointe de contact (22, 32) de l'interface de communication (5).

19. Système de test (1) selon l'une des revendications précédentes, **caractérisé en ce que** le module de test (4) présente une fonction d'autodiagnostic qui vérifie une ou plusieurs fonctions, en particulier le fonctionnement de la matrice de relais et/ou du multiplexeur (24), d'un capteur et/ou d'un pilote (29) d'un deuxième multiplexeur (27), de la puce de communication (28), de l'unité de commande (26) ainsi que de la source de courant et/ou de tension (14), et peut signaler le résultat au système de test (1).

20. Système de test (1) selon l'une des revendications précédentes, **caractérisé en ce que** le module de test (4) présente un module transformateur (45) avec un transmetteur (46), avec lequel une séparation galvanique est réalisée par rapport au module de communication (9) sur la carte imprimée (6) à tester et qui assure une adaptation dans le sens d'une liaison Ethernet, en particulier indépendamment du fait qu'il existe ou non une autre liaison électrique avec le module de communication (9) vers une prise Ethernet.
